Europäisches Patentamt

European Patent Office

Office européen des brevets

(11) Veröffentlichungsnummer : **0 072 386**
**B1**

(12) **EUROPÄISCHE PATENTSCHRIFT**

(45) Veröffentlichungstag der Patentschrift :
05.06.85

(21) Anmeldenummer : 81730076.7

(22) Anmeldetag : 19.08.81

(51) Int. Cl.⁴ : **G 01 V 9/04, H 03 M 1/22,
H 03 M 1/30**

(54) Impulsgeber zum Erzeugen von elektronischen Impulsfolgen.

(43) Veröffentlichungstag der Anmeldung :
23.02.83 Patentblatt 83/08

(45) .Bekanntmachung des Hinweises auf die Patenterteilung : 05.06.85 Patentblatt 85/23

(84) Benannte Vertragsstaaten :
FR GB IT NL SE

(56) Entgegenhaltungen :
EP-A- 0 003 153
DE-A- 2 404 081
US-A- 3 894 232
US-A- 3 902 063
TOUTE L'ELECTRONIQUE, Nr. 405, Dezember 1975,
Seite 88, Paris, FR., "Barrière lumineuse avec indicateur d'angle et compte-tours"

(73) Patentinhaber : MANNESMANN Aktiengesellschaft
Mannesmannufer 2
D-4000 Düsseldorf 1 (DE)

(72) Erfinder : Babsch, Alfred
Jakobstrasse 14
D-7900 Ulm-Söflingen (DE)
Erfinder : Lohrmann, Gerhard
Lerchenweg 30
D-7913 Elchingen 1 (DE)

(74) Vertreter : Meissner, Peter E., Dipl.-Ing. et al
Patentanwälte Dipl.-Ing. Peter E. Meissner Dipl.-Ing.
Hans-Joachim Presting Herbertstrasse 22
D-1000 Berlin 33 (DE)

## Beschreibung

Die Erfindung betrifft einen Impulsgeber gemäß Oberbegriff des Patentanspruches 1. Derartige Impulsgeber zum Erzeugen von elektronischen Impulsfolgen, auch Taktstationen oder opto-elektronische Inkrementalgeber genannt, erfüllen die Aufgabe, rotatorische oder translatorische Bewegungen eines Maschinenteiles, beispielsweise einer drehenden Welle oder die Bewegung eines Schlittens, in definierte Einzelschritte zu zerlegen. Diese Einzelschritte treten als Impulsfolge in Erscheinung, wobei die Frequenz dieser Impulsfolge ein Maß für die Geschwindigkeit des betreffenden Maschinenteiles ist. Durch den Vergleich zweier gleichzeitig erzeugter Impulsfolgen, die zueinander jedoch eine Phasenverschiebung aufweisen, läßt sich darüber hinaus die Bewegungsrichtung elektronisch ermitteln. Die Phasenverschiebung bzw. der Versatz der Inkremente der beiden Impulsfolgen muß z. B. bei einem Druckschlitten eines Matrixdruckers 90° betragen. Diese um 90° versetzten Signale können auch einem Inkrementalzähler zugeführt werden, über den die jeweilige Position, Geschwindigkeit und/oder die Bewegungsrichtung des Maschinenteiles erfaßt wird.

Bei den für die Steuerung von Matrixdruckern in der Praxis bekannten Taktstationen, die mit einer Lichtquelle als Strahlenquelle und mit lichtempfindlichen Strahlenempfängern arbeiten, sind zwei Strahlenquellen als Sender und zwei Empfänger vorgesehen. Die Strahlenempfänger sind so weit voneinander entfernt, daß die Lichtimpulse von verschiedenen Schlitzen der Impulsblende ausgehen. Derartige Einrichtungen erfordern daher einen extrem hohen Aufwand an Präzision in der Fertigung, an Montage und Justierung, um die Phasenverschiebung genau auf 90° einzustellen.

Fernerhin ist ein fotoelektrischer Tastkopf bekannt (DE-B 23 39 874), bei dem die beiden einem einzigen Bereich · zugeordneten Abtastvorrichtungen an einem gemeinsamen, um einen zwischen den Abtastvorrichtungen liegenden Schwenkpunkt verdrehbaren und feststellbaren Träger angebracht wird. An dem Träger sind zum Schwenkpunkt konzentrische Stellschlitze vorgesehen, in denen der Träger mittels Feststellschrauben feststellbar ist. Eine derartige Einrichtung ist nicht nur bezüglich der Drehwinkeleinstellbarkeit sehr aufwendig, sondern erfordert auch einen extrem hohen Aufwand an Präzision in der Fertigung und an Montage. Außerdem ist für die Justierung die Einstellung von drei Schrauben erforderlich, die lediglich der Befestigung des Trägers dienen. Ein derartiger Aufwand ist im Verhältnis zur erreichten Genauigkeit des Systems nicht wünschenswert.

Der bekannte Vorschlag löst allerdings auch die spezielle Aufgabe, einen Abtastkopf so auszubilden, daß auch bei geringem Abstand der Schlitze die Impulsfolgen an im wesentlichen der gleichen Stelle des Umfangs der Scheibe abgegriffen werden, um einen Einfluß von Taumelbewegungen der Scheibe auf die Phasenbeziehung der Impulsfolgen zu vermeiden.

Demgegenüber liegt der vorliegenden Erfindung die Aufgabe zugrunde, den gattungsgemäßen Impulsgeber bezüglich der Einstellbarkeit der beiden Strahlenempfänger auf die gewünschte Phasenverschiebung zu verbessern.

Erfindungsgemäß wird zur Lösung der gestellten Aufgabe vorgeschlagen, den Impulsgeber gemäß den im Patentanspruch 1 niedergelegten Merkmalen zu gestalten. Als drehwinkeleinstellbarer Rotationskörper kommt insbesondere eine Gewindeschraube in Betracht. Über das Feingewinde einer derartigen Gewindeschraube ist es möglich, eine weitaus genauere Winkelverstellung vorzunehmen als dies über die bekannten Klemmvorrichtungen, bestehend aus Stellschlitzen und Feststellschrauben möglich ist. Damit kann die Einstellung des Abstandes der beiden Strahlenempfänger in Bewegungsrichtung der Impulsblende gesehen durch Verdrehen des Trägerkörpers sehr feinfühlig vorgenommen werden.

Die im Patentanspruch 2 vorgesehene Maßnahme ermöglicht es, ausgewählte Lichtstrahlenbündel konzentriert auf die Strahlenempfänger zu leiten und eine Lichtstreuung zu vermeiden.

Für Taktstationen, die als Impulsblende eine rotierende Scheibe aufweisen, sind die Maßnahmen der Patentansprüche 4 und 5 vorgesehen. Dabei zeigt Patentanspruch 4, wie durch einfache Untersetzungsmittel ein feinfühliges Einstellen der Drehpostion des Trägerkörpers möglich ist. Diese einfache Einstellbarkeit ermöglicht es auch, den die Strahlenquelle aufnehmenden Teil der Taktstation als U-förmiges Tragelement aufsteckbar und damit schnell auswechselbar zu gestalten. Eine solche Auswechselbarkeit ist dann von besonderem Vorteil, wenn beispielsweise ein Matrixdrucker auf einen anderen Punktabstand in der Druckzeile eingestellt werden soll.

Ausführungsbeispiele der Erfindung sind in der Zeichnung dargestellt und werden im folgenden näher beschrieben. Es zeigen

Figur 1   eine Taktstation zum Erfassen einer translatorischen Bewegung,

Figur 2   einen Schnitt durch Fig. 1 gemäß der Schnittlinie A-A,

Figur 3   eine Taktstation zum Erfassen einer rotatorischen Bewegung,

Figur 4   eine Draufsicht der Taktstation gemäß Fig. 3, und

Figur 5   eine Darstellung einer Einzelheit aus Fig. 3 mit zerlegten Teilen.

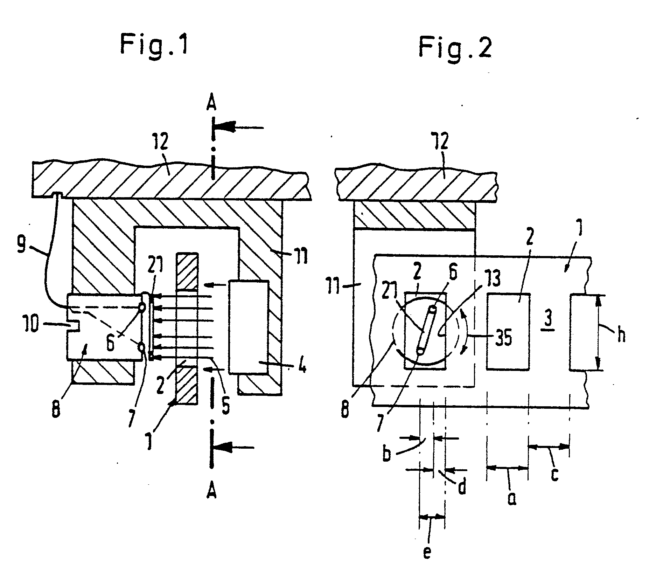

Die in den Figuren 1 und 2 dargestellte Taktstation enthält eine Impulsblende 1, hier in Form eines Bandes, die eine Vielzahl von gleichmäßig auf das Band verteilte, nebeneinanderliegende lichtdurchlässige Impulsblenden-Schlitze 2 aufweist, die durch lichtundurchlässige Stege 3 voneinander getrennt sind. Weiterhin ist eine lichtemittierende Strahlenquelle 4 vorgesehen, wobei die Strahlen durch Pfeile 5 angedeutet sind. Die Strahlenquelle 4 vermag die gesamte Fläche eines Impulsblenden-Schlitzes 2 auszuleuchten, kann sich aber auch flächig über mehrere Impulsblenden-Schlitze erstrecken.

Auf der anderen Seite der Impulsblende 1 liegt der Strahlenquelle 4 der Trägerkörper 8 gegenüber, auf dem ein erster Strahlenempfänger 6 und ein zweiter Strahlenempfänger 7 angeordnet sind. Mit dem Trägerkörper 8 ist, wie Fig. 1 zeigt, eine Schlitzblende 21 fest verbunden. Die Schlitzblende 21 ist in Fig. 2 durch zwei parallele Striche zwischen den Strahlenempfängern 6 und 7 angedeutet.

Der Trägerkörper 8 ist, wie auch die Strahlenquelle 4, in einem im wesentlichen U-förmigen Tragelement 11 befestigt. Das Tragelement 11 wiederum ist an einem Schlitten 12 befestigt, der sich relativ zur feststehenden Impulsblende 1 bewegt. Eine Kerbe 10 für den Ansatz eines Schraubenziehers soll die Verdrehbarkeit des Trägerkörpers im Tragelement 11 andeuten.

Fig. 2 zeigt, daß der absolute Abstand des ersten Strahlenempfängers 6 vom zweiten Strahlenempfänger 7 kleiner ist als die Höhe « h » eines Impulsblendenschlitzes 2. Weiterhin liegen die beiden Strahlenempfänger 6, 7 in der dort dargestellten Position des Schlittens 12 innerhalb ein und desselben Impulsblenden-Schlitzes 2. Der erste Strahlenempfänger 6 hat dabei einen Abstand « d » von der benachbarten Kante des Impulsblenden-Schlitzes 2, der kleiner ist als der Abstand « e » des zweiten Strahlenempfängers 7 von der Kante 13. In Bewegungsrichtung der hier aus einem Band bestehenden Impulsblende 1 weisen die beiden Strahlenempfänger 6 und 7 einen Abstand « b » zueinander auf. Entspricht der Abstand « b » der Hälfte der Breite « a » eines Impulsblenden-Schlitzes 2, so beträgt die Phasenverschiebung 90°. Die genaue Einstellung des Abstandes « b » wird jedoch nicht durch Vermessen, sondern mit Hilfe eines Oszilloskopes vorgenommen.

Die um 90° versetzten Signale werden z. B. einem Inkrementzähler zugeführt, über den die jeweilige Position des Maschinenteiles erfaßbar ist.

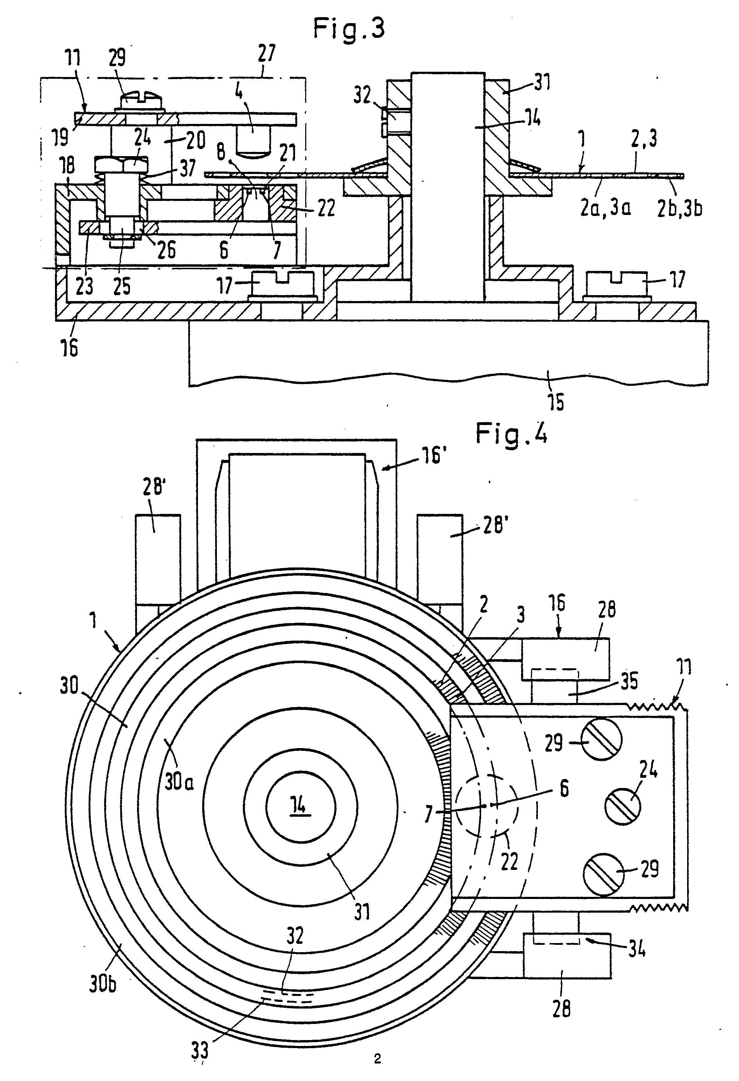

Im übrigen erklärt Fig. 2, daß die Schlitzbreite « a » der Stegbreite « c » entspricht, die Schlitze und Stege regelmäßig geformt sind und in einer gleichmäßigen Teilung angeordnet sind, wie es bei derartigen Impulsblenden, sog. Taktscheiben oder Taktbändern, üblich ist. Der einzelne Schlitz hat gerade Begrenzungen. Für die Taktstation eines Matrixdruckers weist der Schlitz eine Breite « a » von ca. 0,3 mm und eine Höhe von etwa 2,5 bis 3,0 mm auf. Die Stegbreite « c » entspricht der Schlitzbreite. Auf dem Umfang einer Taktscheibe, wie eine solche in den Figuren 3-5 dargestellt ist, sind beispielsweise 200 Schlitze gleichmäßig verteilt.

Die beiden Strahlenempfänger 6, 7 liegen beispielsweise in einem Abstand von 1,5 mm zueinander und sind, wie Fig. 2 zeigt, innerhalb eines Impulsblenden-Schlitzes 2 geringfügig, und zwar um den Abstand « b » in Bewegungsrichtung versetzt, übereinander angeordnet, so daß der erste Strahlenempfänger 6 einen geringeren Abstand, nämlich den Abstand « d » von der nächsten Begrenzung 13 aufweist, als es dem Abstand « e » des zweiten Strahlenempfängers 7 entspricht.

Fig. 3 zeigt eine Taktstation zum Messen einer Rotationsbewegung, wofür die Impulsblende 1 als Impulsscheibe ausgebildet ist. Fig. 4 zeigt die Einrichtung gemäß Fig. 3 in der Draufsicht. Die Impulsblende 1 ist auf der Motorwelle 14 eines Motors 15 über eine Nabe 31 befestigt und über eine Arretierschraube 32 gegen Verdrehen gesichert.

Am Motor 15 befindet sich ein Rahmen 16 mittels Schrauben 17 befestigt. Am Rahmen 16 ist ein im wesentlichen U-förmiges Tragelement 11 angeordnet, zwischen dessen Schenkeln 18 und 19 die Impulsblende 1 hineinragt. Abstandselemente 20 sichern den hierfür erforderlichen Abstand. An dem einen Schenkel 19 ist die Strahlenquelle 4, am anderen Schenkel der Trägerkörper 8 mit den beiden Strahlenempfängern 6 und 7 befestigt. Der Trägerkörper 8 ist drehfest in eine Fassung 22 eingesetzt, wobei an die Fassung 22 ein einarmiger Stellhebel 23 angeschlossen ist. Der Stellhebel 23 weist im Bereich seines freien Endes die Kulisse 26 für einen Exzenter 25 an dem Stellbolzen 24 auf, der in dem Schenkel 18 drehbar und über den Federring 37 in der eingestellten Drehposition gehalten ist.

Gemäß Fig. 4 ist ersichtlich, daß die Impulsblende 1 mehrere konzentrische Bahnen 30, 30a, 30b aufweist, denen die Impulsblenden-Schlitze 2, 2a und 2b sowie die Stege 3, 3a und 3b zugeordnet sind. Die beiden Strahlenempfänger 6 und 7 sind auf die mittlere Bahn 30 eingestellt. Der erste Strahlenempfänger 6 ist dabei der Spur 33 und der zweite Strahlenempfänger 7 der Spur 32 zugeordnet.

Für den Fall, daß auf die Abtastung beispielsweise der äußeren Bahn 30b umgestellt werden soll, kann auf den zweiten Tragrahmen 16' mit Steckführungen 28' eine Abtastvorrichtung, die in Fig. 3 durch ein strichpunktiertes Rechteck 27 angedeutet ist, aufgesteckt werden, wobei diese Abtastvorrichtung in ihrer Geometrie auf die äußere Bahn 30b eingerichtet ist. Die in den Fig. 3 und 4 eingezeichnete Abtastvorrichtung, die in Steckführungen 29 passende Steckelemente 35 am Schenkel 18 aufweist, kann, wenn sie nicht mehr gebraucht wird, abgezogen werden. Hierfür eignet sich besonders, wie beschrieben, die Steckverbindung 34.

Die Schrauben 29 dienen der Verbindung der beiden Schenkel 18 und 19.

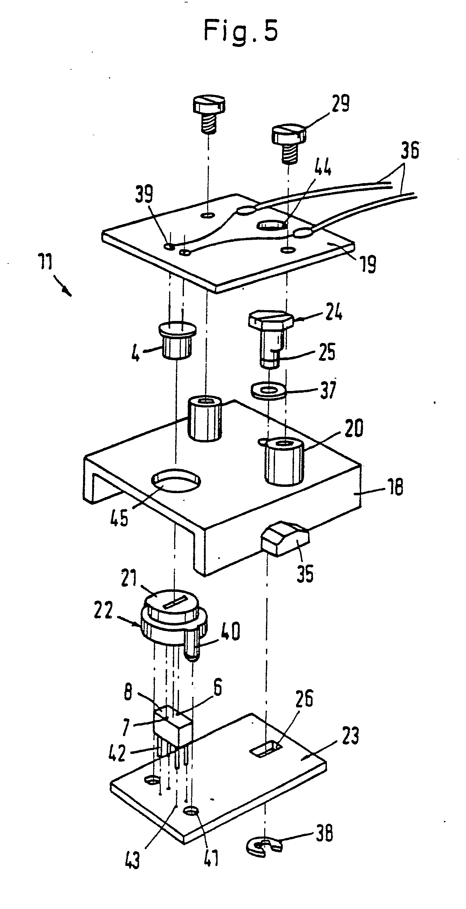

Die Abtasteinheit ist in Fig. 5 in einer zerlegten Darstellung wiedergegeben. Der Schenkel 19 besitzt Steckanschlüsse 39 für die Strahlenquelle 4, die an Stromzuführungen 36 angeschlossen ist.

Der Schenkel 18 weist eine Öffnung 45 für den Durchtritt der Lichtstrahlen auf.

Der Trägerkörper 8 mit den beiden Strahlenempfängern 6 und 7 ist überseine vier Anschlüsse 42, die an ein in Fig. 1 dargestelltes mehradriges Kabel 9 angeschlossen sind, in entsprechende Steköffnungen 43 des plattenförmig ausgebildeten Stellhebels 23 eingesteckt. Über den Trägerkörper 8 wird die Fassung 22 gestülpt und ebenfalls über eine Steckverbindung mit dem Stellhebel 23 verbunden. Zu der Steckverbindung gehören Steckstifte 40 an der Fassung 22 und Steköffnungen 41 im Stellhebel 23. Die Fassung 23 trägt außerdem die Schlitzblende 21.

Im Stellhebel 23 ist die Kulisse 26 für den Exzenter 25 am Stellbolzen 24 vorgesehen. Der Stellbolzen 24 wird mittels des Sprengringes 38 axial gesichert. Zum Verdrehen des Stellbolzens 24 dient ein Schraubenzieher, den man durch eine Öffnung 44 im Schenkel 19 steckt.

In der Zeichnung nicht dargestellt sind die sich an die Taktstation anschließenden, dem Fachmann geläufigen elektronischen Einrichtungen, mit deren Hilfe die Primärimpulse bzw. Spannungsschwankungen in Inkrementalschwingungen umgewandelt werden.

**Patentansprüche**

1. Impulsgeber zum Erzeugen von elektrischen Impulsfolgen zwecks Messung der Position, der Geschwindigkeit und/oder der Bewegungsrichtung eines bewegten Maschinenteiles (14), insbesondere der Bewegungen des Druckschlittens eines Matrixdruckers, mit einer Lichtschränke, die aus einer Strahlenquelle (4), einer quer zum Strahlengang bewegten Impulsblende (1) und zwei Strahlenempfängern (6, 7) besteht, die auf der der Strahlenquelle (4) abgewandten Seite der Impulsblende (1) an einem Trägerkörper (8) befestigt sind, wobei der auf die Bewegungsrichtung der Impulsblende (1) bezogene Abstand der beiden Strahlenempfänger (6, 7) durch Drehung des Trägerkörpers (8) um eine senkrecht zur Impulsblendenebene verlaufende Drehachse einstellbar ist, dadurch gekennzeichnet, daß der Trägerkörper (8) aus einem drehbar gelagerten Rotationszylinder besteht, daß die Strahlenempfänger (6, 7) an der einen Stirnseite des Rotationskörpers (8) der Impulsblende (1) gegenüberliegend im Strahlengang der einzigen Strahlenquelle (4) befestigt sind und daß an der anderen Stirnseite des Rotationszylinders (8) eine Kerbe (10) für ein handbetätigtes drehwerkzeug vorgesehen ist.

2. Impulsgeber nach Anspruch 1, dadurch gekennzeichnet, daß für beide Strahlenemfänger (6, 7) eine einzige, den Strahlengang begrenzende, zwischen den Strahlenempfängern (6, 7) und der Impulsblende (1) angeordnete, mit dem Trägerkörper (8) drehbare Schlitzblende (21) vorgesehen ist.

3. Impulsgeber nach den Ansprüchen 1 und 2, dadurch gekennzeichnet, daß die Impulsblende (1) sich senkrecht zur Bewegungsrichtung dieser Blende erstreckende Impulsblendenschlitze (2) aufweist, und daß der Abstand der Strahlenempfänger (6, 7) zueinander auf ein Maß (b) einstellbar ist, das halb so groß ist wie die Breite (a) der Impulsblenden-Schlitze (2).

4. Impulsgeber nach einem der Ansprüche 1 bis 3, dadurch gekennzeichnet, daß die Impulsblende (1) als rotierende Scheibe mit kreisförmig verteilten Impulsblendenschlitzen (2) ausgebildet ist, und daß ein ortsfestes, im wesentlichen U-förmiges Trageelement (11) vorgesehen ist, zwischen dessen Schenkeln (18, 19) die Scheibe (1) hineinragt, daß an einem Schenkel (19) die Strahlenquelle (4), am anderen Schenkel (18) der Trägerkörper (8) mit den beiden Strahlenempfängern (6, 7) befestigt ist, daß am Trägerkörper (8) oder an einer den Trägerkörper (8) drehbar im Schenkel (18) haltenden Fassung (22) ein einarmiger Stellhebel (23) befestigt ist und daß im Bereich des freien Hebelendes im Stellhebel (23) eine Kulisse (26) für einen Exzenter (25) eines im Schenkel (18) gelagerten verdrehbaren Stellbolzen (24) vorgesehen ist.

5. Impulsgeber nach den Ansprüchen 1 bis 4, dadurch gekennzeichnet, daß das Trageelement (11) mit dem Rahmen (16) mittels einer Steckverbindung (34) lösbar verbunden ist.

**Claims**

1. Impulse transmitter for the production of electrical impulse sequences for the purpose of measuring the position, the speed and/or the direction of motion of a moving machine part (14), in particular the movements of the print sliding carriage of a matrix printer, with a light barrier, which consists of a beam source (4), an impulse aperture (1) moving transversely to the path of beam and two beam receivers (6, 7), which are attached to a support member (8) on the side of the impulse aperture (1) facing away from the beam source (4), whereby the distance between the two beam receivers (6, 7), relating to the direction of motion of the impulse aperture (1), is adjustable by rotation of the support member (8) about an axis of rotation running vertically to the plane of the impulse aperture, characterized in that the support member (8) consists of a rotatably mounted rotational cylinder, that the beam receivers (6, 7) are attached on the one front face of the rotational member (8) lying opposite the impulse aperture in the beam path of the single beam source (4) and that on the other front face of the rotational cylinder (8) a notch (10) is provided for a hand-operated rotational tool.

2. Impulse transmitter according to Claim 1, characterized in that for both beam receivers (6, 7) a single slotted aperture (21) is provided, delimiting the beam path, and which is arranged between the beam receivers (6, 7) and the impulse aperture (1), and which is rotatable with the support member (8).

3. Impulse transmitter according to Claims 1 and 2, characterized in that the impulse aperture (1) has impulse aperture slots (2) extending vertically to the direction of motion of this aperture, and that the distance of the beam receivers (6, 7) one from the other is adjustable to a measurement (b) which is half as great as the width (a) of the impulse aperture slots (2).

4. Impulse transmitter according to one of Claims 1 to 3, characterized in that the impulse aperture (1) is constructed as a rotating disc with impulse aperture slots (2) distributed in the form of a circle, and that a fixed, substantially U-shaped bearing element (11) is provided, in between the shanks (18, 19) of which the disc (1) extends, that on one shank (19) the beam source (4) is attached, and on the other shank (18) the support member (8) with the two beam receivers (6, 7) is attached, that on the support member (8) or on a mounting (22) holding the support member (8) rotatably in the shank (18) a one-armed adjustable lever (23) is attached and that in the region of the free lever end in the adjustable lever (23) a slideway (26) is provided for an eccentric (25) of an adjustable pin (24) which is able to be twisted and which is mounted in the shank (18).

5. Impulse transmitter according to Claims 1 to 4, characterized in that the bearing element (11) is detachably connected with the frame (16) by means of a plug connection (34).

### Revendications

1. Générateur d'impulsions destiné à produire des suites d'impulsions électriques pour mesurer la position, la vitesse et/ou le sens du mouvement d'un élément de machine (14) en mouvement, en particulier les mouvements du chariot d'impression d'une imprimante à matrice, pourvu d'une barrière lumineuse qui se compose d'une source de rayons (4), d'un écran d'impulsions (1) mobile transversalement au trajet des rayons et deux récepteurs de rayons (6, 7) qui sont fixés sur la face de l'écran d'impulsions (1) opposée à la source de rayons (4) sur un corps de support (8), la distance entre les deux récepteurs de rayons (6, 7) par rapport au sens du mouvement de l'écran d'impulsions (1) étant réglable en tournant le corps du support (8) autour d'un axe de rotation perpendiculaire au plan de l'écran d'impulsions, caractérisé en ce que le corps de support (8) comporte un cylindre de rotation monté rotatif, en ce que les récepteurs de rayons (6, 7) sont fixés sur l'une des faces frontales du corps de rotation (8) en regard de l'écran d'impulsions (1) dans le trajet des rayons provenant de l'unique source de rayons (4) et en ce que sur l'autre face frontale du cylindre de rotation (8) il est prévu une encoche (10) pour un outil de commande de rotation manuel.

2. Générateur d'impulsions selon la revendication 1, caractérisé en ce qu'il est prévu, pour les deux récepteurs de rayons (6, 7) un seul écran à fentes (21) limitant le trajet des rayons, disposé entre les récepteurs de rayons (6, 7) et l'écran d'impulsions (1), rotatif avec le corps de support (8).

3. Générateur d'impulsions selon les revendications 1 et 2, caractérisé en ce que l'écran d'impulsions (1) présente des fentes (2) s'étendant perpendiculairement au sens du mouvement de cet écran et en ce que l'intervalle entre les récepteurs de rayons (6, 7) est réglable sur une dimension (b) qui est égale à la moitié de la largeur (a) des fentes (2) de l'écran d'impulsions (1).

4. Générateur d'impulsions selon l'une quelconque des revendications 1 à 3, caractérisé en ce que l'écran d'impulsions (1) est formé par un disque rotatif comportant des fentes (2) réparties circulairement et en ce qu'il est prévu un élément porteur (11) fixe, sensiblement en forme de U, entre les branches (18, 19) duquel le disque (1) saille, en ce que sur l'une des branches (19) est fixée la source de rayons (4), sur l'autre branche (18) le corps de support (8) avec les deux récepteurs de rayons (6, 7), en ce que sur le corps de support (8) ou sur un châssis maintenant le corps de support (8) rotatif dans la branche (18) est fixé un levier de commande (23) à un bras et en ce que dans la zone de l'extrémité libre du levier il est prévu, dans le levier de commande (23) une coulisse (26) pour un excentrique (25) d'un axe de réglage (24) monté rotatif dans la branche (18).

5. Générateur d'impulsions selon l'une quelconque des revendications 1 à 4, caractérisé en ce que l'élément porteur (11) est relié de façon amovible au cadre (16) au moyen d'une liaison enfichable (34).

# Fig.1

# Fig.2

0 072 386

Fig.3

Fig.4

# Fig. 5

3